Europäisches Patentamt

European Patent Office

Office européen des brevets

(11) Publication number: **0 224 141**
**A2**

## (12) EUROPEAN PATENT APPLICATION

(21) Application number: 86115795.6

(22) Date of filing: 13.11.86

(51) Int. Cl.⁴: **H01L 29/08** , H01L 23/36

(30) Priority: 21.11.85 US 800251

(43) Date of publication of application:
03.06.87 Bulletin 87/23

(84) Designated Contracting States:
CH LI SE

(71) Applicant: **GENERAL ELECTRIC COMPANY**
**1 River Road**
**Schenectady New York 12305(US)**

(72) Inventor: **Cusano, Dominic Anthony**
**2017 Morrow Avenue**
**Schenectady New York 12309(US)**

(74) Representative: **Catherine, Alain et al**
**General Electric - Deutschland Munich**
**Patent Operation Frauenstrasse 32**
**D-8000 München 5(DE)**

(54) Improved semiconductor power devices.

(57) An improved power semiconductor device can be fabricated by encasing a conventional semiconductor device within a pair of degeneratively doped semiconductor heat sink electrodes. Thermal compatibility between the device and the degeneratively doped semiconductor heat sink electrode avoid thermal stress and allows the device to rapidly dissipate heat to the heat absorbing electrodes. A degeneratively doped heat sink electrode can be attached to the surface device by a eutectic bond and can be used to seal an otherwise exposed surface of the device.

Fig. 1

EP 0 224 141 A2

## IMPROVED SEMICONDUCTOR POWER DEVICES

This invention relates to semiconductor power devices which generate significant amounts of heat during their operation and more particularly, to an integrated structure in which one or more semiconductor heat sink electrodes are permanently bonded to the substrate of a conventional semiconductor device.

### Prior Art

Known thyristors and diodes are typically assembled with a number of plates, spacers, and rings within metal packages. The packages are constructed to exert tremendous pressure on the enclosed components to maintain electrical contact between the components. A typical 50 mm diameter thyristor employs a thick alloy-bonded tungsten or molybdenum plate on one side of the silicon wafer and a second loose tungsten or molybdenum plate on the opposite side. Ring-shaped plates are typically employed as electrodes for three terminal devices or when a portion of a device requires electrical isolation. Dry interfaces are commonly employed throughout the construction and extremely high clamping forces are required to operate the device. The constructions are heavy, bulky, and are expensive to manufacture. Special cooling mechanisms are required to efficiently operate these devices. Moreover, these packages are not readily adaptable to power devices having diameters in excess of 75 mm. U.S. Patent 4,129,243 to Cusano et al. discloses an illustrative example of a conventional housing for a semiconductor power device.

### Summary of the Invention

The present invention provides an improved semiconductor power device wherein a degenerately doped and highly conductive semiconductor electrode is permanently bonded to at least one surface, such as the anode surface of a conventional semiconductor power device which acts as a substrate for the improved device. The semiconductor electrode, when attached to the substrate of the convention a device, forms a low resistance electrical contact with a terminal of the device and also functions as a high thermal conductivity heat sink to dissipate sufficient amounts of heat during thermal surges to avoid heat damage to the device.

In a preferred embodiment, both the electrode and device can be made from silicon. As explained below, the improvements disclosed herein are particularly applicable to recessed gate devices.

The semiconductor electrode can have a coefficient of thermal expansion essentially equal to the coefficient of thermal expansion of the substrate of the conventional device. The electrode can be attached to the substrate by a hard alloy bond to avoid slip or creep between the electrode and the device. An aluminum silicon eutectic bond can be made to provide a low resistance electrical connector and a negligible barrier to heat flow from the device to the electrode. The surface of the semiconductor heat sink electrode not in contact with the conventional device can readily join or contact additional structures to dissipate heat from the electrode.

A eutectic bond between the substrate and the electrode can, for instance, be established by coating one surface of the device substrate and one surface of the electrode with an aluminum layer having a thickness of approximately .5 mils or less. The two coated surfaces can then be placed adjacent each other to form a sandwich-like structure which is then heated in a hydrogen atmosphere at a temperature of approximately 580°C to form a eutectic bond between the surfaces. The aluminum coating can be applied by, for instance, sputtering or vacuum deposition. A second degeneratively doped semiconductor electrode can be similarly applied to the second or opposite surface of the semiconductor device substrate by a similar technique.

Additional more massive heat sinks and external metal electrodes can be attached to the semiconductor heat sink electrode by soft solders, or epoxy bonding to the semiconductor electrodes and can be attached after the semiconductor heat sink electrode is attached to the substrate. In one embodiment, the heat sink electrode does not cover the entire surface of the device and a passivation layer is applied to the device surface and the adjacent surfaces of the electrode to hermetically seal the otherwise exposed surface of the device within the electrode.

### Brief Description of the Drawings

The features of the present invention, considered to be patentable to applicant, are specified in the claims appended hereto. The invention itself, however, both as to organization and method of operation, together with further objects, features and advantages thereof, may be best understood with reference to the following detailed description when read in conjunction with the accompanying drawings in which:

Figure 1 is an exploded cross-sectional view of an improved semiconductor device in accordance with the present invention;

Figure 2 is a cross-sectional view of an assembled device in accordance with the present invention.

Figure 3 is a top plan view in partially section of an edge gated power thyristor 25 may be employed in the structure of Figures 1 and 2.


Description of the Drawings

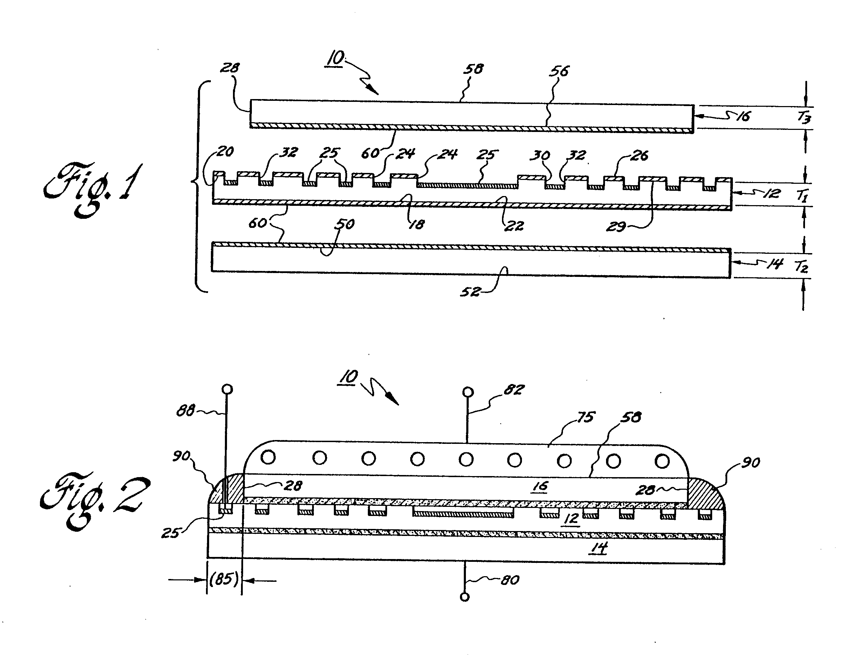

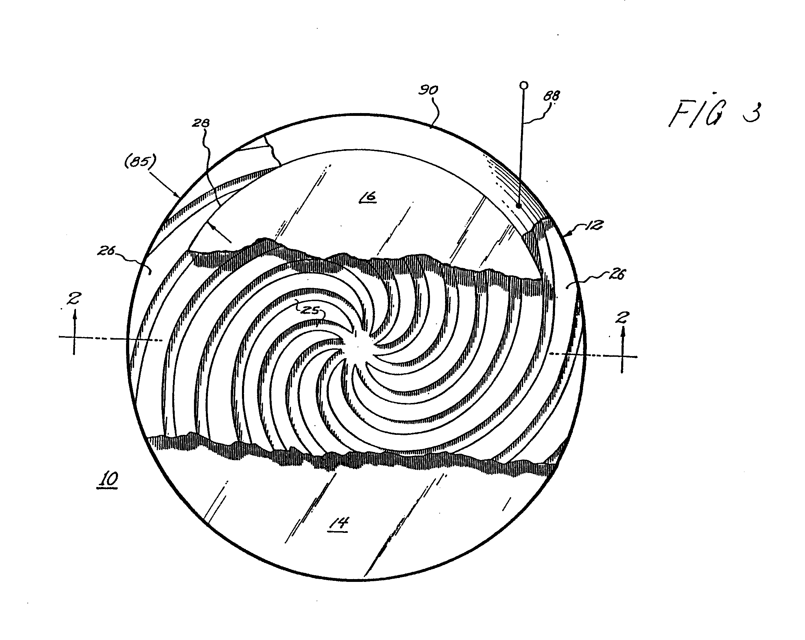

Referring now to Figure 1, an improved semiconductor power device 10 in accordance with the present invention is shown in an exploded partial cross-sectional illustration. The improved semiconductor device 10 is shown to include a conventional semiconductor device as a substrate member 12 and first and second semiconductor heat sink electrodes 14 and 16, respectively, for attachment to the substrate. While the conventional semiconductor device 12 can comprise a number of different power devices, for the purposes of illustration, the device 12 has been selected to have a recessed gate structure and can, for instance, be an edge-gated silicon power thyristor which has been fabricated of a silicon wafer. The configuration of the device may be more apparent from Figure 3 discussed below. In particular, the gate electrode can have an involute structure. The conventional semiconductor device substrate 12, shown in Figure 1, includes a first lower surface 18 and a second upper surface 20. In the selected silicon power thyristor example, a first terminal 22, such as a substantially planar anode terminal 22, has been fabricated in the first surface 18 of the device 12 and second and third terminals 24 and 25 respectively, have been fabricated in the second surface 20 of the device. In the illustrated example of a power thyristor having a recessed involute gate structure, the second terminal 24 appears as a plurality of mesa cathodes while the third terminal 25 appears as a plurality of recessed gates. The cathode terminal 24 is illustrated as an unrecessed region 26 having a substantially planar upper surface 29 and substantially cylindrical interior and exterior walls 30 and 32, respectively. The circular shaped cathode and gate terminals 24 and 25 respectively, can be considered to circumferentially define each other's boundaries.

As illustrated in Figure 1, the first and second semiconductor heat sink electrodes 14 and 16 have been fabricated as substantially planar semiconductor wafers having interior surfaces which are intended to join or contact the first and second surfaces 18 and 20, respectively, of the device 12. If the first and second surfaces 18 and 20 of the device 12 are irregular, the corresponding electrode can include the mirror image of the irregularity to provide a mating contact. The first semiconductor electrode is typically provided with substantially planar first and second surfaces 50 and 52. The first surface 50 is substantially coextensive with the substrate 12 of the device and is specially configured to engage substantially the entire lower surface of the substantially planar first or anode terminal 22 of the device 12.

The second electrode 16 in the illustrated typical example is also substantially planar and has first and second substantially planar surfaces 56 and 58. The first surface 56 is configured to engage substantially the entire surface 29 of the second or cathode terminal 24 of the device 12 disposed on the second surface 20 thereof. In the illustrated example, the second electrode 16 makes electrical contact with only the cathode electrode 24 and does not make electrical contact with the gate electrode 25.

The second electrode 16 in the illustrated embodiment is less than coextensive with the conventional device 12 and does not cover the entire second surface 20 of the device 12. Immediate and direct access to an exposed portion of the gate electrode 25 disposed about the periphery of the device 12 is provided in the illustrated example. In an alternate embodiment, not illustrated, wherein the gate electrode is configured as a central electrode involute gate, the second electrode 16 can be coextensive with the substrate and can, for instance, have a central opening for providing access to the central gate electrode and to allow an appropriate connection to be made thereto. As discussed below, portions of the device terminals not covered by an electrode can be sealed with a passivation layer.

It is preferred that each of the first and second electrodes 14 and 16, respectively, be fabricated from degeneratively doped highly electrically conductive semiconductor material having a coefficient of thermal expansion essentially equal to the coefficient of thermal expansion of the substrate containing the conventional device 12. It is also preferred that the electrodes 14 and 16 be fabricated from degenerately doped polycrystalline semiconductor materials such as low cost single crystalline, poly quality, or polycrystalline silicon. In the illustrated embodiment employing a silicon device, the electrodes 14 and 16 are fabricated from silicon wafers.

It is also preferred that the first and second electrodes 14 and 16 respectively, have a thickness $T_2$ and $T_3$, each of which is less than the thickness $T_1$ of the device substrate 12 of the conventional device.

In a typical example, the substrate 12 exhibits a thickness in the range of 30-50 mils, and the first and second electrodes exhibit thicknesses in the range of 20-40 mils. Typically, the substrate 12 can have a radius of approximately 3 inches or more. The improved semiconductor device embodiment described herein can be advantageously implemented as a high power device or a device which, under reverse bias conditions, can block up to several thousand volts, and typically block voltages in the range of 2000-6000 volts.

It is preferred that the first and second electrodes 14 and 16 respectively, be permanently attached to the terminal surfaces of the semiconductor power device 12 by, for instance, a hard alloy or eutectic bond. It has been found that an aluminum silicon eutectic bond fixedly attaches the first and second silicon electrodes 14 and 16 respectively, to the first and second surfaces 18 and 20 of the semiconductor device 12 in a manner to avoid slip or creep between the electrode and the substrate of the device 12.

In order to form an aluminum eutectic bond between the first and second electrodes 14 and 16 and the first and second device surface 18 and 20 respectively, the following steps are commonly performed. First, each surface of the device 12 and electrodes 14 and 16 to be bonded is coated with a thin film or layer of aluminum 60, preferably having a thickness in the range of .1-.5 mils. This layer of aluminum can be applied, for instance, by vacuum deposition or sputtering.

The corresponding aluminum coated surfaces of the device and electrode are then engaged. In the illustrated example, a three layer sandwich comprising the second electrode 16, the device 12, and the first electrode 14 is formed. The sandwich is then heated in, for instance, a hydrogen atmosphere for a period of one half an hour at a temperature in the range of 500°C-700°C to establish a eutectic bond between the substrate 12 and electrodes 14 and 16. It is preferred that all bonding be accomplished at temperatures less than 700°C to avoid unwanted impurity diffusions in the semiconductor materials to avoid harm to the device 12.

As illustrated in Figure 2, once the appropriate bonds have been formed between the electrodes 14 and 16 and the substrate 12, the improved device 10 comprises a unitary package having a three layer structure of semiconductor electrode 14, semiconductor device substrate 12 and semiconductor electrode 16 or in the example under consideration, silicon electrode 14, silicon device substrate 12 and silicon electrode 16. These semiconductor electrodes 14 and 16, in addition to providing low electrical resistance contacts between the device 12 and an external terminal also serve to reduce the thermal stress applied to the device inasmuch as the coefficients of thermal expansion of the electrodes 14 and 16 closely matches the coefficient of thermal expansion of the device 12. Moreover, the electrodes 14 and 16 readily absorb heat from the device 12 and contribute to improved thermal dissipation from the improved device comprising the conventional device 12 encased within the semiconductor electrodes 14 and 16. Accordingly, the improved packaged device 12 is better able to withstand heat surges by readily dissipating the generated heat. This is because inter alia, the eutectic bond is an essentially negligible thermal barrier which allows heat from the semiconductor device 12 to readily travel into the electrodes 14 and 16 to a depth of approximately 30 mils in less than 8.3 milliseconds to avoid damage to the device following each half cycle current/power surge in normal 60 Hz operation.

As illustrated in Figure 2, an additional external heat sink 75 can be applied to either or both the electrodes 14 and 16. In the illustrated embodiment, the additional heat sink 75 is applied only to the second surface 58 of the second electrode 16. The more massive heat sink 75 can be fluid cooled. External terminals 80, 82, and 88 can be applied respectively to the anode, cathode, and gate terminals of the device 12. Epoxy, soft solder, or other low temperature bonding techniques can be used to attach the heat sink 75 or external terminal 80 and 82 to the appropriate electrode 14 or 16 to avoid damage to the previously formed eutectic bond between the electrodes 14 and 16 and the device 12. Alternatively, the heat sink 75 and terminal 80 can be attached by high temperature bonding; however, it is preferred that the high temperature bond be accomplished prior to formation of the eutectic bonds between the electrodes 14 and 16 and device substrate 12 to avoid contamination of the device which might otherwise occur by thermally inducing impurities to enter the device 12. Alternatively, the massive aluminum or copper heat sinks 75 can be attached to the encased or improved device by a liquid metal interface, for instance, using a gallium layer.

The electrodes 14 and 16 are permanently bonded to the device 12 and essentially hermetically seal those surfaces of the device 12 which they cover. The edge region 85 of the device, such as the cathode surface 20 not covered by and projecting past the electrode 16, can also be sealed with a passivation layer 90 to provide a hermetic enclosure for the device. The edge region 85 of the device 12 containing a portion of the gate electrode 25 which projects past the electrode 16, can have an external terminal 88 connected thereto and can be covered with appropriate passivation material 90 such as room temperature vulcanizable silicon (RTV) or alternatively, a native semiconductor oxide such as silicon dioxide. The passivation material 90 coats and seals all exposed surfaces of the device 12 and the adjacent surface 28 of the electrode. In the illustrated example, the passivation material 90 can coat and seal the cathode surface 20, the gate surface 25 and the adjacent surface 28 of the electrode 16. It is preferred in the illustrated example that passivation layer 90 coat the entire periphery of the cathode 24, the gate 25, and the adjacent edge 28 of the electrode 16 to seal the second surface 20 of the device 12 within the electrode 16.

Figure 3 is a top plan view partially in cut away of the packaging system 10 of the present invention. The second electrode 16 is fixedly secured to the second surface 20, shown in Figure 1, of the device substrate 12. In the illustrated example, the device 12 is a thyristor having gate and cathode electrodes 24 and 26, respectively, interlaced in an involute structure on the upper surface 20 of the device 12. As shown in Figures 2 and 3, the edge gate terminal 88 passes through and is sealed within a layer of native oxide 90 such as silicon dioxide. The cathode terminal 82 is not shown in Figure 3. The first electrode 14 supports the device 12 from beneath. The first and second electrodes, in combination with the oxide layer 90, form a hermetically sealed all semiconductor package 10 for the device 12. The more massive heat sinks 75 have been omitted from Figure 3.

It is to be understood that other configurations of the device 12 and electrodes 14 and 16 will be readily apparent to those skilled in the art. In particular, it is recognized that more than one electrode can be attached by a low temperature bond and further, that one electrode can cover only a portion of the device surface together with one or more other electrodes covering the remaining portion of the entire surface.

While the present invention has been shown with reference to the preferred embodiment, it will be understood that the present invention will admit to modifications, changes, variation, substitutions, and equivalents as might occur to those skilled in the art without departing from the spirit and scope of this invention. Accordingly, it is intended that the invention herein be limited only by the appended claims.

## Claims

1. An improved semiconductor power device comprising:
a semiconductor power device fabricated as a substantially planar semiconductor wafer;
a degeneratively doped semiconductor heat sink electrode fabricated as a substantially planar semiconductor wafer having first and second surfaces, one of said first and second surfaces being configured for matingly engaging said first substantially planar surface of said power device; and
a low resistance thermally conductive bond attaching said electrode to said mating surface of said device wafer.

2. The improved semiconductor power device of claim 1 wherein said semiconductor device and electrode wafers are silicon wafers.

3. The improved semiconductor power device of claim 2 wherein at least one surface of said electrode is coated with aluminum and at least one surface of said semiconductor device is coated with aluminum.

4. The improved semiconductor device of claim 1 wherein said electrode is attached to said semiconductor device by an aluminum-eutectic bond.

5. The improved semiconductor device of claim 1 wherein said semiconductor device surface includes at least one recessed terminal.

6. The improved semiconductor device of claim 1 wherein said semiconductor device is a silicon device and said electrode is a low cost crystalline silicon electrode.

7. The improved semiconductor device of claim 1 wherein the coefficient of thermal expansion of said electrode is approximately equal to the coefficient of thermal expansion of said device substrate.

8. The improved semiconductor device of claim 1 wherein at least one massive heat sink is attached by a soft solderless bond to the other of said first and second surfaces of said heat sink electrode.

9. The improved semiconductor device of claim 2 wherein a second degeneratively doped semiconductor heat sink electrode is attached to said second surface of said device.

10. The improved semiconductor device of claim 1 wherein an exposed portion of said first surface of said device is not covered by said electrode, and a passivation layer coating said exposed portion of said surface of the device and an adjacent portion of the electrode to seal the device.

11. A method of fabricating an improved semiconductor device comprising the steps of:
applying an aluminum coating to each of the mating surfaces of a semiconductor device and semiconductor electrode;

placing said aluminum coated device surface adjacent said aluminum coated electrode surface;

forming a eutectic bond between said adjacent aluminum coated surfaces by heating said surfaces in an atmosphere of hydrogen at a temperature in excess of 500°C.

12. The method of forming an improved semiconductor device of claim 11 wherein said aluminum coating is applied in a thickness of approximately .5 mils.

13. The method of claim 11 wherein said aluminum coating is applied by sputtering.

14. The method of claim 11 wherein said aluminum coating is applied by vacuum deposition.

15. The method of claim 11 further including the step of applying a second silicon electrode to a second substantially planar surface of said semiconductor device.

16. The method of claim 11 further including the step of attaching a heat sink to said electrode of said semiconductor device by epoxy bonding to said electrode.

17. The method of claim 10 wherein said step of attaching said heat sink to said electrode is performed after the step of attaching said electrode to said semiconductor device.

*Fig.1*

28  10  58  56

16  $T_3$

20  32  25  60  24  24  25  30  32  26

12  $T_1$

60  50  18  22  29

14  $T_2$

52

*Fig.2*

10

88

82

90

75  58

16

28  28

25

12

90

14

(85)

80

0 224 141

FIG 3

0 224 141